Europäisches Patentamt

European Patent Office

Office européen des brevets

(19)

(11) Publication number: **0 018 764**
**B1**

# EUROPEAN PATENT SPECIFICATION

(45) Date of publication of patent specification: **14.03.84**

(21) Application number: **80301294.7**

(22) Date of filing: **23.04.80**

(51) Int. Cl.³: **H 01 L 27/10,**
**G 11 C 11/24, H 01 L 29/78**

(54) **A semiconductor memory device in which soft errors due to alpha particles are prevented.**

(30) Priority: **02.05.79 JP 54606/79**

(43) Date of publication of application:
**12.11.80 Bulletin 80/23**

(45) Publication of the grant of the patent:
**14.03.84 Bulletin 84/11**

(84) Designated Contracting States:
**DE FR GB NL**

(56) References cited:
**FR - A - 2 336 801**
**GB - A - 2 002 584**

**IBM TECHNICAL DISCLOSURE BULLETIN, vol. 15, no. 9, February 1973, New York, USA, D.R. YOUNG "Reducing detrimental minority carrier effects in semiconductor devices", pages 2707-2708**
**ELECTRONIC DESIGN, vol. 26, no. 11, May 1978, Rochelle-Park, USA, "Alpha particles may be cause of soft errors in memory", page 37**

(73) Proprietor: **FUJITSU LIMITED**
**1015, Kamikodanaka Nakahara-ku**
**Kawasaki-shi Kanagawa 211 (JP)**

(72) Inventor: **Sakurai, Junji**
**7-11, Seta 4-chome**
**Setagaya-ku Tokyo 158 (JP)**

(74) Representative: **Allman, Peter John et al,**
**Marks and Clerk Scottish Life House Bridge Street**
**Manchester M3 3DP (GB)**

A semiconductor memory device in which soft errors due to alpha particles are prevented

This invention relates to a semiconductor memory device in which soft errors due to stray minority carriers generated by alpha particles are prevented.

In recent years, large scale integrated semiconductor devices, such as 64K or 256K random access memories (RAM), have been developed. In such semiconductor devices, the size of each cell and the amount of charge capable of being stored in each cell is very small. When alpha particles are radiated on the surface of the semiconductor device, soft errors may often occur because of the small charge storage. The soft error mechanism is as follows. That is, low levels of alpha particles ($<0.1$ counts/cm$^2 \cdot$ h) are emitted from a very small amount of uranium (U) or thorium (Th) included in the immediate environment of the chip, such as found in a package of the semiconductor device. Each of the incident alpha particles interacts with silicon (Si) in the semiconductor device to create a track of electron-hole pairs along the straight-line path of the particles. Therefore, electron-hole pairs are produced in a charge storage region at the surface of the substrate and also in the silicon substrate itself. When the substrate is of a P type, electrons derived from the electron-hole pairs produced in the substrate are thermally diffused isotropically and the electrons thus diffused and which have fallen into the depletion layer are injected, by an electric field, into the charge storage region at the surface of the substrate or into a diffusion region connected to a bit sense line. If there is no electron in the charge storage region, that is, if the information stored in the charge storage region is "0", the electrons injected into the charge storage region destroy the information "0" so that the information "0" is changed to "1". Thus, a soft error is produced.

The depth of penetration or range of the alpha particles in the silicon substrate is about 25 $\mu$m and the width of the substrate is usually greater than 200 $\mu$m. Therefore, the alpha particles, which may cause these soft errors, are those injected from the front surface of the substrate where active regions of the semiconductor device are present. The alpha particles injected from the back surface of the substrate are not a real problem.

These soft errors can be repaired by rewriting correct data and thus are different from hard errors, which are due to defects in the structure of the semiconductor device. However, in order to eliminate the rewriting process, it is preferable that soft errors do not occur.

As a counterplan for suppressing the influence of the alpha particles injected from the surface of the semiconductor substrate, a film made of, for example, lead or resin, for stopping the injection of the alpha particles may be coated over the surface of the semiconductor device. However, if such a stopping film is used, it is required that the film satisfy various conditions, as follows:

(1) the film must be capable of stopping the injected particles,

(2) the film itself must not include any source of alpha particles,

(3) the film must adhere closely to the chip of the semiconductor device without exfoliation and without causing distortion of the chip,

(4) the film must be sufficiently insulated electrically from lead wires, and

(5) the coating of the film must be inexpensive.

Because of these conditions, it is not easy to form a lead film capable of stopping injected alpha particles. In addition, the film coating on the silicon chip such as a lead or resin film generally is ineffective in its stopping power against high-energy cosmic rays.

In IBM TDB, Vol. 15, No. 9, February 1973 at pages 2707—8 it is proposed to provide a depletion region in the vicinity of a device to carry away into a non-critical region generated minority carriers which might otherwise diffuse to the depletion regions of semiconductor devices (e.g. CCDs and photodetectors) and lead to lead to undesirable currents therein.

In FR—A—2336801, equivalent to US—A—4163245, in an integrated circuit comprising an MOS transistor and a MOS capacitor store, a reverse-biased PN junction is provided about the MOS capacitor to absorb minority carriers generated in the transistor and other components of the circuit which could otherwise reach and discharge the store.

It is an object of the present invention to provide a semiconductor memory device having a charge storage region, in which device the structure has been improved to prevent soft errors from occurring due to stray minority carriers generated by alpha particles.

According to the present invention there is provided a semiconductor memory device in which soft errors due to alpha particles are prevented, comprising:

a semiconductor substrate (1) of one conductivity type, and:

dynamic memory cells formed on said semiconductor substrate, each dynamic memory cell comprising one MOS transistor and one capacitor, said MOS transistor comprising a source diffusion region and a drain diffusion region, and said capacitor operatively forming a charge storage region;

characterised in that:

each of said dynamic memory cells further comprises a surface layer (2) of the same conductivity type as that of said semiconductor substrate but having a higher concentration than that in said semiconductor substrate, so as to provide a built-in potential barrier V(Bi) satisfying the condition V(Bi)>KT/q (where K is Boltzman's constant, T is absolute temperature and q is the charge on an electron), the potential barrier V(Bi) confining substrate generated minority carriers in the semiconductor substrate and said surface layer being formed on said semiconductor substrate and surrounding entirely said source drain, and charge storage regions.

The present invention will now be described with reference to the accompanying drawings, in which:

Fig. 1 is a cross-sectional view of a memory cell, including one transistor and one MOS capacitor, in a dynamic RAM in which soft errors due to alpha particles are prevented by the potential barrier of a conventional P-N junction;

Fig. 2 is an equivalent circuit diagram of the memory cell of Fig. 1;

Fig. 3 is a graph diagram illustrating an electric potential distribution in the RAM of Fig. 1;

Fig. 4 is a cross-sectional view of a memory cell including one transistor, in a buried-storage type RAM in which soft errors due to alpha particles are prevented by the potential barrier of a conventional P-N junction, and;

Fig. 5 is a cross-sectional view of a conventional charge-coupled device (CCD) in which soft errors due to alpha particles are prevented by the potential barrier of a conventional P-N-junction.

The principle of operation of a potential barrier in preventing soft errors due to alpha particles will now be described with reference to the conventional P-N junctions of the devices shown in the accompanying drawings.

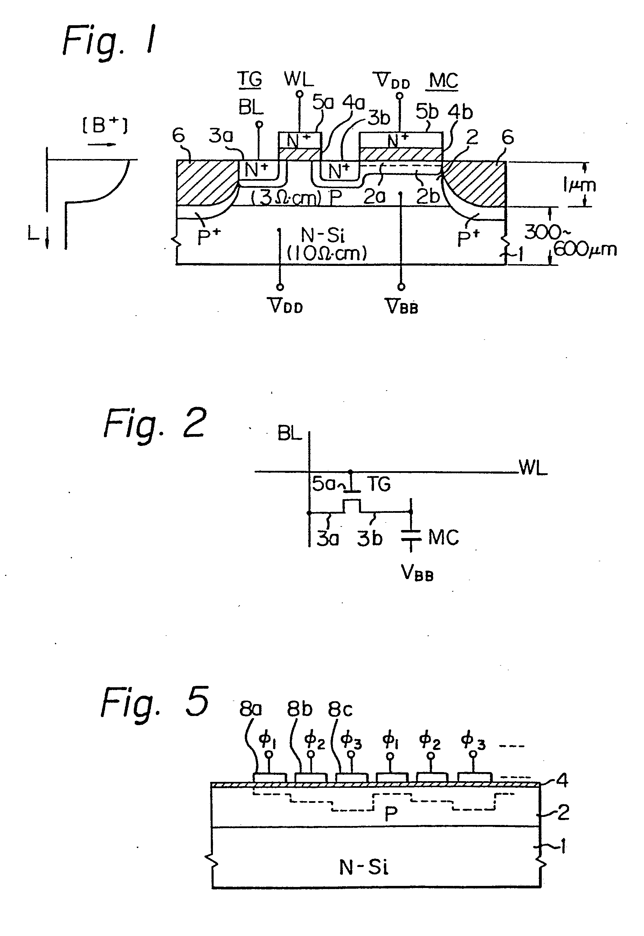

Referring to Fig. 1 there is shown a cross-section of a memory cell of a dynamic RAM. In Fig. 1, the dynamic RAM includes a silicon substrate 1. The substrate 1 is of an N-type and has a thickness of about 300 through 600 $\mu$m. The specific resistance of the substrate 1 is about 10 $\Omega \cdot$ cm. At the surface of the silicon substrate 1, a P-type surface layer 2, having a thickness of about 1 $\mu$m and a specific resistance of about 3 $\Omega \cdot$ cm is formed by diffusing a large amount of P-type impurities sufficient to form the P-type layer 2, and boron ions are diffused into the surface of the substrate 1. By this diffusion of boron ions, the concentration of the boron ions (B$^+$) is highest at the surface layer 2 and gradually decreases along the depth L of the surface layer 2, as illustrated in the graph on the left hand side of Fig. 1. The concentration curve of boron ions corresponds to the potential energy curve of an electron. As a result, a potential barrier is formed between the P-type surface layer 2 and the N-type silicon substrate 1.

After forming the surface layer 2, P$^+$ channel cut regions, an insulating layer 6 made of silicon dioxide, N$^+$ diffusion layers 3a and 3b which are drain and source regions of an MOS FET which is a so called transfer gate TG, gate oxide layers 4a and 4b, and N$^+$ polysilicon layers 5a and 5b are formed by conventional MOS technology. The N$^+$ layer 5a is the gate electrode of the FET. The oxide layer 4b and the N$^+$ polysilicon layer 5b constitute an MOS capacitor MC. When a plus voltage V$_{DD}$ of, for example, 5 V is applied to the N$^+$ polysilicon layer 5b, the conductivity of the surface of the P-type surface layer 2 directly under the oxide layer 4b is inverted. As a result, a charge storage region 2a for storing electrons is formed at that surface of the surface layer 2. Between the inverted N-type region, or, in other words, the electron storage region 2a, and the P-type surface layer 2, a depletion layer 2b is formed, according to the well known principle of a PN junction. The depletion layer 2b extends to the region between the N$^+$ diffusion region 3b and the surface layer 2. The N$^+$ diffusion region 3b, or, in other words, the source of the FET, is connected to the charge storage region 2b. The gate electrode 5a and the drain electrode 3a are connected respectively to the word line WL and the bit line BL.

Since an electron from an electron-hole pair produced by an alpha particle has a thermal energy of about 0.024 eV, the amount of boron ions diffused to form the surface layer 2 must be sufficient to form a potential barrier which has a potential energy greater than 0.024 eV. By this potential barrier, electrons having an energy of about 0.024 eV cannot reach the active region, as hereinafter described in detail.

In order to ensure the function of the potential barrier, it is preferable to apply a low voltage V$_{BB}$ to the surface layer 2 and a high voltage V$_{DD}$ to the silicon substrate 1, so that the P-N junction between the surface layer 2 and the substrate 1 is reverse biased.

Fig. 2 is an equivalent circuit diagram of the memory cell of Fig. 1. As shown in Fig. 2, the source 3b, the gate 5a and the drain 3a are connected respectively to the electrode of the MOS capacitor MC, the word line WL and the bit line BL. The electrode of the MOS capacitor MC is also connected to the high voltage V$_{DD}$. Another electrode of the MOS capacitor is connected to the substrate 1 (Fig. 1).

The operation of the memory cell of Fig. 2 is well known and, to explain briefly, when the transfer gate TG is opened, charges are transferred into the MOS capacitor MC for storage in a programming process and these charges are read out in a reading out process.

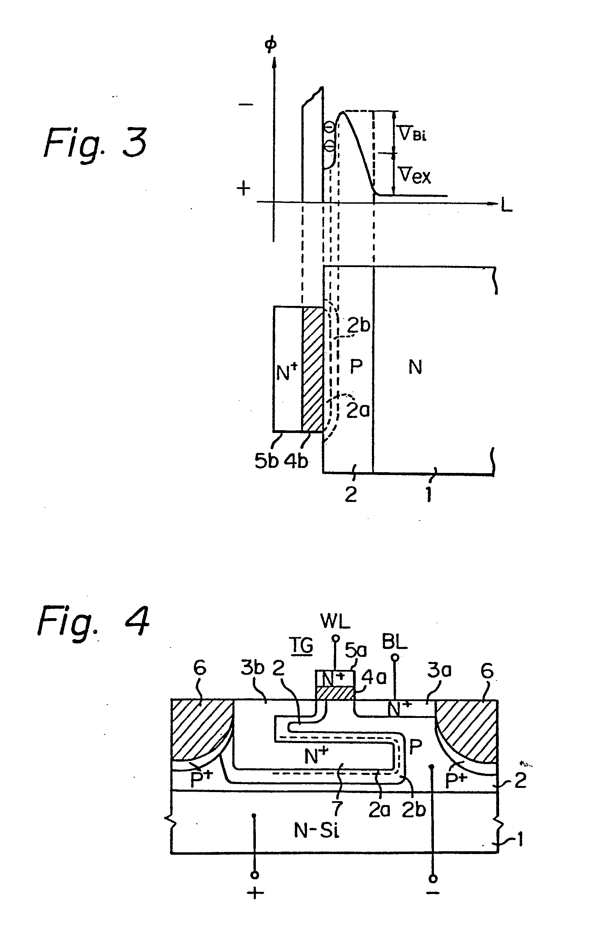

Fig. 3 is a graph diagram illustrating the potential distribution across the MOS capacitor MC in the cell of Fig. 1, and explains how soft errors due to alpha particles are prevented by the potential barrier. In Fig. 3, the ordinate $\phi$ represents the electric potential of an electron and the abscissa L represents the distance from the surface of the N$^+$ polysilicon layer 5b towards the back surface of the silicon substrate 1. As illustrated in Fig. 3, the electric potential is relatively low in the charge storage region 2a. The potential gradually increases through the depletion layer 2b and reaches its highest value at the surface of the P-type surface layer 2 directly under the depletion layer 2b. Because the concentration of the impurities (boron ions) in the surface layer 2 decreases along with the increase in distance L, the potential gradually decreases, as illustrated by a solid curve in Fig. 3, from the highest level to the lowest level in the surface layer 2. The lowest potential is maintained in the N-type silicon substrate 1. The potential barrier for electrons is thus obtained.

Referring to Fig. 1 and Fig. 3, the operation of preventing soft errors due to alpha particles by the potential barrier will now be described. Since the penetration depth of alpha particles in a silicon semiconductor is about 25 $\mu$m and the depth of the source region 3a or drain region 3b is only about 0.5 $\mu$m and the thickness of the surface layer 2 is only about 1 $\mu$m, an alpha particle radiated onto the front surface of the semiconductor device of Fig. 1 can reach through the source region 3a or drain region 3b and the surface layer 2 into the inside of the silicon substrate 1. Along the track of the alpha particle, electron-hole pairs are produced. The produced electrons and holes are thermally diffused isotropically. Most of the electron-hole pairs are produced in the substrate 1, because the thickness (1 $\mu$m) of the surface layer 2 is much less than the penetration depth (25 $\mu$m) of the alpha particles. When there are almost no electrons in the charge storage region 2a, in other words, when the memory cell represents the information "0", and if a part of the produced electrons reaches the charge storage region 2a, a soft error will occur. However, since the potential barrier for electrons is formed in the surface layer 2, electrons produced in the substrate 1 cannot reach the charge storage region 2a. A small amount of electron-hole pairs may be produced in the depletion layer 2b. These electrons produced in the depletion layer 2b are attracted by the electric field and are injected into the charge storage region 2a. However, as described above, since the thickness of the surface layer 2 is much thinner than the penetration depth of the alpha particles, the thickness (0.5 $\mu$m) of the depletion layer 2b in the surface layer 2 is also much thinner than the penetration depth of the alpha particles. Therefore, the amount of electrons injected from the depletion layer 2b to the charge storage region 2a is extremely small, so that the injected electrons do not cause a soft error as long as the minimum amount of electrons stored in the charge storage region 2a when the memory cell stores information "1" is not extremely small. Consequently, soft errors due to alpha particles are prevented by the operation of the potential barrier.

If the P-N junction between the N-type substrate 1 and the P-type surface layer 2 is reverse biased, the height of the potential barrier is increased. That is, as illustrated in Fig. 3, the height of the potential barrier is $V_{ex}$ plus $V_{Bi}$, where $V_{ex}$ represents the external voltage difference between $V_{DD}$ and $V_{BB}$, and $V_{Bi}$ represents the component of the potential barrier due to the P-N junction or, in other words, a built-in potential. Therefore, by applying a reverse bias voltage $V_{ex}$, the potential barrier is increased by the voltage $V_{ex}$. If the thermal energy of an electron is greater than the potential barrier component due to the P-N junction, the electron can go over the potential barrier when the reverse bias voltage is not applied to the P-N junction. In general, the external voltage $V_{ex}$, the potential difference $V_{Bi}$ due to the P-N junction and the thermal energy of an electron KT must satisfy the relation:

$$V_{Bi}+V_{ex}>KT/q$$

where K represents the Boltzman constant, T represents the absolute temperature and q represents the charge of an electron.

Fig. 4 is a cross-sectional view of a part of a buried-storage type RAM. As such a buried-storage type RAM, there is a V-MOS RAM or a BO-MOS RAM. The difference between the structure of the RAM of Fig. 4 and the structure of the RAM of Fig. 1 is that the RAM of Fig. 4 does not include the MOS capacitor MC but, alternatively, the N$^+$-type buried layer 7 is buried in the P-type surface layer 2. By this construction, the integration degree is increased in comparison with the RAM of Fig. 1. In this embodiment, the charge storage region 2a is formed in the depletion layer 2b between the N$^+$-type buried layer 7 and the P-type surface layer 2. The equivalent circuit of the RAM of Fig. 4 is also illustrated in Fig. 2. The operation of the RAM of Fig. 4 is equivalent to that of the RAM of Fig. 1, and, thus is not described here.

Fig. 5 is a cross-sectional view of a charge-coupled device (CCD). In this device the thin P-type surface layer 2 is also formed on the N-type silicon substrate 1. An insulating layer 4 is formed on the surface layer 2. Transfer electrodes 8a, 8b, 8c, ... are formed on the insulating layer 4. Three phase clock pulses, $\phi_1$, $\phi_2$, $\phi_3$, ... are applied to these transfer electrodes for transferring charges by a well known conventional method.

The description with respect to the production of an electron-hole pair due to an alpha particle, the prevention of the thermally diffused electron of the electron-hole pair from injecting into the charge storage region by means of the P-N junction between the P-type surface layer 2 and the N-type silicon substrate 1, and the effect of the reverse bias mentioned before with respect to the RAM of Fig. 1 can also be adapted to the RAM of Fig. 4 and to the CCD of Fig. 5.

Instead of forming the surface layer 2 in the RAM of Fig. 1, in the RAM of Fig. 4 or in the CCD of Fig. 5 by diffusing P-type impurities, the surface layer 2 may be formed by means of the epitaxial growth method. When the epitaxial growth method is employed, the potential barrier is not gradually decreased along with the depth of the surface layer 2, as illustrated in Fig. 3 by the solid curve, but, is decreased as illustrated by a dashed line in Fig. 3, whereby the level of the potential barrier is highest and substantially constant throughout the surface layer 2 and then suddenly decreases to the lowest level at the surface of the N-type silicon substrate. Therefore, if an electron-hole pair is produced in the surface layer 2, the possibility of the electron falling into the charge storage region 2a to cause a soft error is substantially the same as the possibility of the electrons being diffused into the N-type substrate 1. In contrast to this, when the surface layer 2 is formed by the diffusion method, the electron produced in the surface layer 2 is certain to fall into the N-type substrate 1. Accordingly, the diffusion method is more efficient in preventing soft errors due to alpha particles than the epitaxial growth method. However, since most of the electron-hole pairs are produced in the substrate 1, as mentioned above, prevention by employing the epitaxial growth method is practical and satisfactory.

In the devices described hereinabove, the potential barrier is formed by the P-N junction between the P-type surface layer 2 and the N-type substrate 1. In the present invention, however, the potential barrier is formed by means of forming a concentration difference of impurities of the same conduction type, For example, a P-type semiconductor material may be used as the substrate 1 and a P$^+$-type surface layer 2 having a higher concentration than the P-type substrate may be formed on the substrate 1 by means of diffusion or epitaxial growth as mentioned hereinabove. Also for example, a P-type surface layer 2 may be formed on the P$^-$-type substrate 1 having a lower concentration than the P-type surface layer. It should be noted that, when the concentration difference is utilized for forming the potential barrier, the external voltage $V_{ex}$ cannot be applied. However, the built-in potential $V_{Bi}$ can be obtained between the P$^+$- or P-type surface layer 2 and the P- or P$^-$-type substrate 1. As long as the built-in potential $V_{Bi}$ satisfies the condition $V_{Bi} > KT/q$, the built-in potential acts satisfactorily as a potential barrier for electrons produced by alpha particles.

From the foregoing description, it will be understood that, according to the present invention, charges produced by alpha particles can be prevented from being diffused into the charge storage region of a semiconductor device without preparing a special film. Consequently, in a semiconductor device having a charge storage region, a soft error can be prevented easily and with certainty.

## Claims

1. A semiconductor memory device in which soft errors due to alpha particles are prevented, comprising:

a semiconductor substrate (1) of one conductivity type; and

dynamic memory cells formed on said semiconductor substrate, each dynamic memory cell comprising one MOS transistor and one capacitor, said MOS transistor comprising a source diffusion region and a drain diffusion region, and said capacitor operatively forming a charge storage region;

characterised in that:

each of said dynamic memory cells further comprises a surface layer (2) of the same conductivity type as that of said semiconductor substrate but having a higher concentration than that in said semiconductor substrate, so as to provide a built-in potential barrier V(Bi) satisfying the condition V(Bi)>KT/q (where K is Boltzman's constant, T is absolute temperature and q is the charge on an electron), the potential barrier V(Bi) confining substrate generated minority carriers in the semiconductor substrate and said surface layer being formed on said semiconductor substrate and surrounding entirely said source, drain, and charge storage regions.

2. A semiconductor memory device as claimed in claim 1 wherein the thickness of said surface layer is less than 1/300 of the thickness of said semiconductor substrate so as to ensure that most electron-hole pairs are produced in said semiconductor substrate.

3. A semiconductor memory device as claimed in claim 1 or 2, wherein said capacitor comprises a buried layer of the same conductivity type as that of said semiconductor substrate, said buried layer being formed in said surface layer.

## Patentansprüche

1. Halbleiterspeichervorrichtung, in welcher ein durch alpha-Teilchen verursachter "Soft error" verhinder ist,

mit einem Halbleitersubstrat (1) vom nichtleitenden Typ,

und mit auf dem genannten Halbleitersubstrat ausgebildeten dynamischen Speicherzellen, welche jeweils einen MOS-Transistor und einen Kondensator umfassen von denen der MOS-Transistor einen Sourcediffusionsbereich und einen Draindiffusionsbereich umfaßt und der Kondensator als Ladungsspeicherbereich wirkend ausgebildet ist,

dadurch gekennzeichnet, daß jede dynamische Speicherzelle ferner eine Oberflächenschicht (2) von selben Leitfähigkeitstyp wie das genannte Halbleitersubstrat umfaßt, jedoch mit einer höheren Konzentration als in dem genannten Halbleitersubstrat, um so einen eingebauten Potentialwall V(Bi) zu bilden, welcher die Bedingung V(Bi)>KT/q (wobei K die Boltzmannkonstante, T die absolute Temperatur und q die Ladung eines Elektrons ist), wobei der Potentialwall V(Bi) in dem Substrat erzeugte Minoritätsträger in dem Halbleitersubstrat einschließt und die genannte Oberflächenschicht auf dem genannten Halbleitersubstrat ausgebildet ist und die Source-, Drain- und Ladungsspeicherbereiche vollständig umgibt.

2. Halbleiterspeichervorrichtung nach Anspruch 1, bei welcher die Dicke der genannten Oberflächenschicht kleiner als 1/300 der Dicke des genannten Halbleitersubstrates ist, um sicher zu stellen, daß die meisten Elektronen-Loch-Paare in dem genannten Halbleitersubstrat· erzeugt werden.

3. Halbleiterspeichervorrichtung nach Anspruch 1 oder 2, bei welcher der genannte Kondensator eine vergrabene Schicht vom selben Leitfähigkeitstyp wie das Halbleitersubstrat umfaßt und die vergrabene Schicht in der genannten Oberflächenschicht ausgebildet ist.

**Revendications**

1. Dispositif de mémorisation à semi-conducteur dans lequel les erreurs faibles dues à des particules alpha sont empêchées, comprenant:

un substrat semi-conducteur (1) d'un premier type de conductivité;
des cellules de mémorisation dynamiques formées sur ledit substrat semiconducteur, chaque cellule de mémorisation dynamique comprenant un transistor MOS et un condensateur, ledit transistor MOS comprenant une région de diffusion de source et une région de diffusion de drain, et ledit condensateur formant fonctionnellement une région d'emmagasinage de charge;

caractérisé en ce que chacune desdites cellules de mémorisation dynamiques comprend en outre une couche superficielle (2) du même type de conductivité que ledit substrat semiconducteur, mais présentant une concentration supérieure à celle dudit substrat semiconducteur, afin de produire une barrière de potentiel incorporée V(Bi) satisfaisant la condition V(Bi)>kT/q (où k est la constante de Boltzman, T est la température absolue et $q$ est la charge de l'électron), la barrière de potentiel V(Bi) confinant les porteurs minoritaires produits dans le substrat à l'intérieur du substrat semi-conducteur et ladite couche superficielle étant formée sur ledit substrat semi-conducteur et entourant entièrement lesdites régions de source, de drain et d'emmagasinage de charge.

2. Dispositif de mémorisation à semi-conducteur selon la revendication 1, où l'épaisseur de ladite couche superficielle est inférieure à 1/300e de l'épaisseur dudit substrate semi-conducteur afin d'assurer que la plupart des paires électron-trou se produisent dans ledit substrat semi-conducteur.

3. Dispositif de mémorisation à semi-conducteur selon la revendication 1 ou 2, où ledit condensateur comprend une couche enterrée du même type de conductivité que ledit substrat semi-conducteur, ladite couche enterrée étant formée dans ladite couche superficielle.

*Fig. 1*

*Fig. 2*

*Fig. 5*

*Fig. 3*

*Fig. 4*